# EUROPÄISCHE PATENTSCHRIFT

(11) **EP 0 999 562 B1**
(45) Veröffentlichungstag und Bekanntmachung des Hinweises auf die Patenterteilung: **15.12.2004**
(21) Anmeldenummer: 99121369.5
(22) Anmeldetag: 27.10.1999
(51) Int. Cl.: H01C 10/48, H01C 10/30

(54) **Trägersubstrat mit einer Widerstandsbahn**
Carrier substrate with resistance strip
Substrat porteur avec bande résistive

(30) Priorität: 05.11.1998 DE 19850936
(43) Veröffentlichungstag der Anmeldung: 10.05.2000
(73) Patentinhaber: Siemens Aktiengesellschaft, 80333 München (DE)
(72) Erfinder: Eichelmann, Claus, 61197 Florstadt (DE)

(56) Entgegenhaltungen:
- EP-A- 0 023 949
- DE-A- 3 227 805
- DE-C- 701 808
- US-A- 5 051 719

## Beschreibung

Die Erfindung betrifft eine Leiterplatte mit einer Widerstandsbahn für ein elektrisches Gerät, bei dem ein Schleifer zur Verbindung mit elektrischer Energie entlang der Widerstandsbahn beweglich ist und die Widerstandsbahn aus zahlreichen, quer zu ihrer Haupterstreckungsrichtung ausgerichteten, mit Abstand zueinander verlaufenden Metallstreifen besteht, welche an einer Seite durch einen definierten, elektrischen Widerstand miteinander verbunden sind, insbesondere für ein Potentiometer eines Hebelgebers zur Niveauanzeige in einem Kraftstofftank, wobei Bereiche von Metallstreifen zu einer Seite der Widerstandsbahn hin Verlängerungen aufweisen, die durch einen Abgleichwiderstand überbrückt sind und wobei der Abgleichwiderstand zum Abtrennen von Widerstandsbereichen durch quer zu den Verlängerungen verlaufende Schnitte ausgebildet ist.

Leiterplatten der vorstehenden Art werden für Niveaugeber in Kraftstofftanks heutiger Kraftfahrzeuge eingesetzt und sind deshalb allgemein bekannt. Elektrische Energie muss jedoch auch für zahlreiche andere Anwendungsfälle von einer Widerstandsbahn mittels eines Schleifers abgegriffen und einem sich bewegenden Bauteil zugeführt werden.

Bei Niveaugebern will man meist erreichen, dass eine Linearität zwischen dem Füllstand und dem Weg des das Niveau anzeigenden Zeigers besteht. Da der Querschnitt von Tanks, in welchen der Füllstand gemessen wird, jedoch über die Höhe des Tanks oftmals stark unterschiedlich ist, um sich räumlichen Gegebenheiten des Kraftfahrzeuges anzupassen, bedingt die Erzeugung dieser Linearität hohen Abgleichaufwand. Bei den bisher bekanntgewordenen Niveaugebern sind die einzelnen Metallstreifen an einer Seite durch eine sie überbrückende Widerstandsfläche miteinander verbunden. Zum Verändern des Widerstandes der Widerstandsbahn schneidet man die Widerstandsfläche zwischen den Metallstreifen radial unterschiedlich weit ein, so dass der elektrische Strom über einen mehr oder minder breiten Restbereich der Widerstandsfläche von einem zum anderen Metallstreifen fließen muss. Das Einschneiden der Widerstandsfläche erfolgt derzeit mittels Laserlicht. Wenn man mit dieser Technik einen Niveaugeber derart abgleichen will, dass eine lineare Kennlinie entsteht, dann würde sich die Anzahl der erforderlichen Laserschnitte etwa verzehnfachen, was eine hohe Rechnerleistung für den automatischen Abgleich erforderlich machen würde und unerwünscht hohe Anforderungen an die Positioniergenauigkeit des Lasers stellt, damit sich die Toleranzen nicht von Laserschnitt zu Laserschnitt unzulässig stark addieren.

In der EP 023 949 A1 wird ein flächig ausgeführter Abgleichwiderstand, der mit Längs- und Querschnitten versehen ist, beschrieben. Die US PS 5,051,719 beschreibt einen ebenfalls flächigen Abgleichwiderstand, dessen Randbereich vollständig abgetrennt werden kann, so dass die seitliche Ausdehnung und damit der elektrische Widerstand des stehen gebliebenen Restes variiert werden kann.

Der Erfindung liegt das Problem zugrunde, eine Leiterplatte mit einer Widerstandsbahn zu entwickeln, welche mit möglichst geringem Aufwand derart abgleichbar ist, dass eine lineare Kennlinie für die Anzeige eines mit einer solchen Leiterbahn arbeitenden Gerätes erreichbar ist.

Dieses Problem wird erfindungsgemäß dadurch gelöst, dass der Abgleichwiderstand aus mehreren, quer zu den Verlängerungen, im Abstand zueinander, parallel laufenden weiteren Widerstandsbahnen besteht, wobei zur Erhöhung des elektrischen Widerstandes zwischen zwei Metallstreifen wenigstens eine Verlängerung vor einer der weiteren Widerstandsbahnen getrennt ist.

Durch eine solche Gestaltung kann man mit relativ geringem Aufwand Widerstandsbereiche abtrennen und dadurch den elektrischen Widerstand in den jeweils gewählten Bereichen gezielt für den gesamten Bereich verändern, indem man mehr oder weniger breite Widerstandsbereiche abtrennt. Da der Abgleich im Bereich der Verlängerungen erfolgt, sind die Abgleichbereiche problemlos auf der Leiterplatte anzuordnen und beeinflussen nicht die Schleiferbewegungen.

Besonders kostengünstig ist es, wenn der Abgleichwiderstand auf den Verlängerungen durch Aufdrucken erzeugt ist und die Schnitte mittels Laserlicht gebildet sind.

Gemäß der Erfindung kann das Abgleichen durch Abtrennen vorher definierter Einzelwiderstände in festgelegten Abgleichschritten und deshalb mit besonders geringem Rechneraufwand erfolgen.

Die Erfindung lässt verschiedene Ausführungsformen zu. Zur weiteren Verdeutlichung ihres Grundprinzips ist eine davon schematisch in der Zeichnung dargestellt und wird nachfolgend beschrieben. Die Zeichnung zeigt in
- Fig. 1: eine Draufsicht auf eine erfindungsgemäße Leiterplatte eines Niveaugebers für einen Kraftstofftank,
- Fig. 2: eine gegenüber Figur 1 im Maßstab vergrößerte Draufsicht auf einen Teilbereich der Leiterplatte.

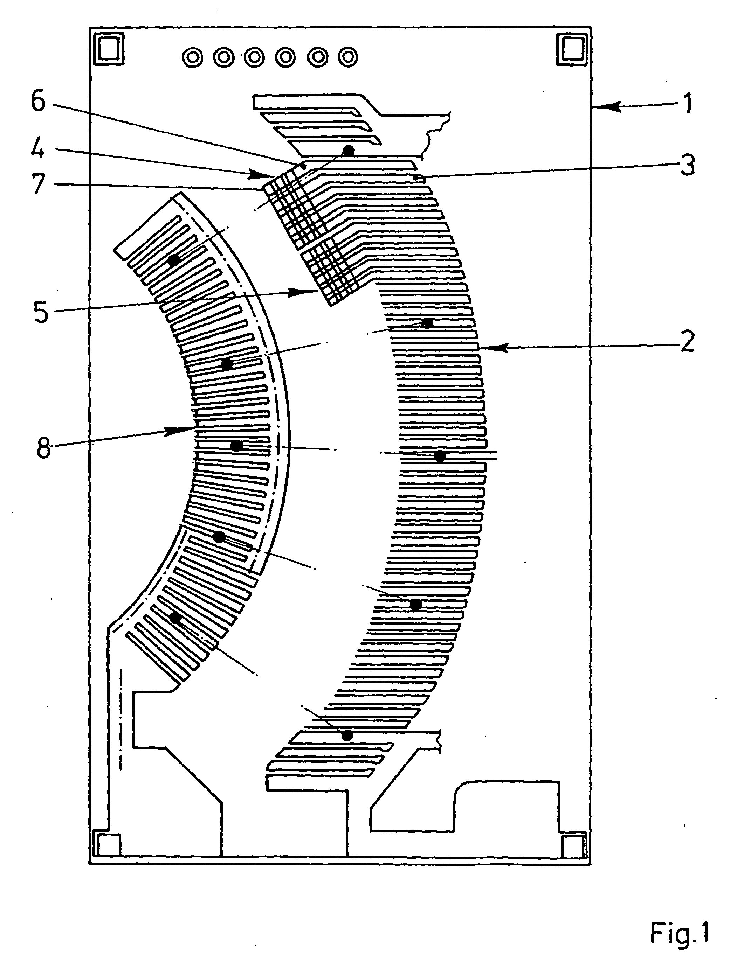

Die Figur 1 zeigt eine Leiterplatte 1 mit einer Widerstandsbahn 2, die aus einzelnen, mit geringem Abstand zueinander, nebeneinander angeordneten Metallstreifen 3 gebildet ist. Wie für zwei Bereiche 4, 5 gezeigt ist, weisen die Metallstreifen 3 jeweils eine Verlängerung 6 auf. Diese Verlängerungen 6 der einzelnen Bereiche 4, 5 sind durch parallel zueinander verlaufende Abgleichwiderstände 7 miteinander verbunden.

Koaxial zu der Widerstandsbahn 2 verläuft auf der Leiterplatte 1 eine Schleiferbahn 8. Nicht dargestellt ist ein Schleifer, welcher sich entsprechend der Bewegungen eines mit einem Schwimmer versehenen, drehbar gelagerten Hebels über die Widerstandsbahn 2 und die Schleiferbahn 8 schleift, dadurch diese miteinander verbindet und ein dem Füllstand in dem Kraftstofftank entsprechendes Signal erzeugt.

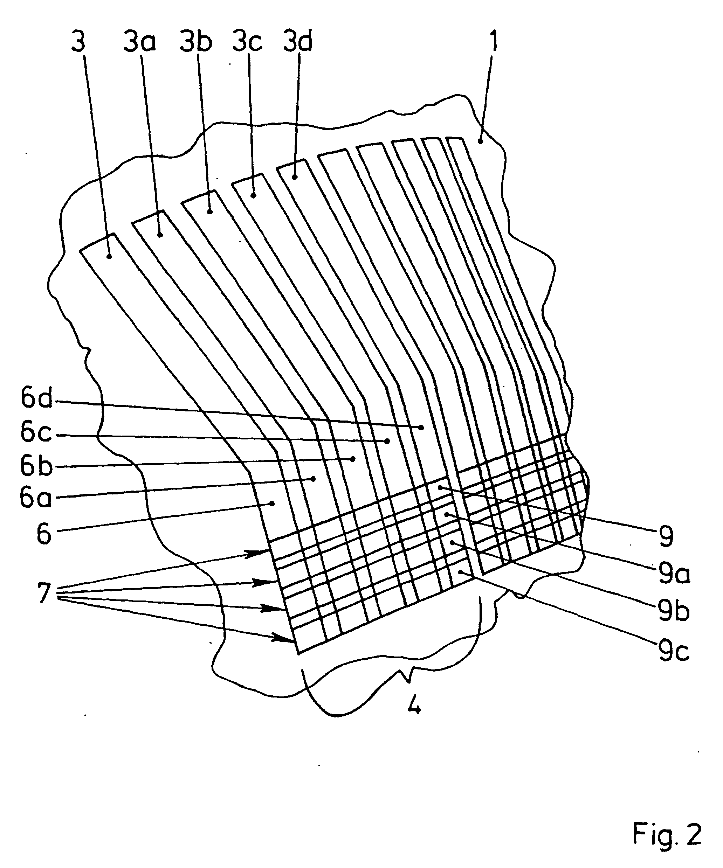

Die Figur 2 verdeutlicht, dass fünf Metallstreifen 3, 3a, 3b, 3c, 3d zu dem Bereich 4 zusammengefasst sind und ihre jeweiligen Verlängerungen 6, 6a, 6b, 6c, 6d durch den Abgleichwiderstand 7 miteinander verbunden sind, der bei diesem Beispiel aus vier mit Abstand zueinander, parallel laufenden Widerstandsbahnen 9, 9a, 9b, 9c besteht.

Die Widerstandsbahnen 9, 9a, 9b, 9c verbinden über die Verlängerungen 6 die Metallstreifen 3, 3a, 3b, 3c, 3d miteinander. Der elektrische Strom fließt von einem zum anderen Metallstreifen 3 über diese Widerstandsbahnen 9, 9a, 9b, 9c. Will man den hierbei zu überwindenden, elektrischen Widerstand erhöhen, dann trennt man mittels Laserlicht beispielsweise die Verlängerungen 6 vor der in der Figur 2 gesehen untersten Widerstandsbahn 9c durch. Soll eine weitere Erhöhung des Widerstandes erfolgen, dann trennt man beispielsweise die Verlängerungen 6 vor den Widerstandsbahnen 9b oder 9a durch.

## Patentansprüche

1. Leiterplatte mit einer Widerstandsbahn für ein elektrisches Gerät, bei dem ein Schleifer zur Verbindung mit elektrischer Energie entlang der Widerstandsbahn beweglich ist und die Widerstandsbahn aus zahlreichen, quer zu ihrer Haupterstreckungsrichtung ausgerichteten, mit Abstand zueinander verlaufenden Metallstreifen besteht, welche an einer Seite durch einen definierten, elektrischen Widerstand miteinander verbunden sind, insbesondere für ein Potentiometer eines Hebelgebers zur Niveauanzeige in einem Kraftstofftank, wobei Bereiche von Metallstreifen (3) zu einer Seite der Widerstandsbahn (2) hin Verlängerungen (6) aufweisen, die durch einen Abgleichwiderstand (7) überbrückt sind und wobei der Abgleichwiderstand (7) zum Abtrennen von Widerstandsbereichen durch quer zu den Verlängerungen (6) verlaufende Schnitte ausgebildet ist, **dadurch gekennzeichnet, dass** der Abgleichwiderstand (7) aus mehreren, quer zu den Verlängerungen (6), im Abstand zueinander parallel laufenden weiteren Widerstandsbahnen (9, 9a, 9b, 9c) besteht, wobei zur Erhöhung des elektrischen Widerstandes zwischen zwei Metallstreifen (3) wenigstens eine Verlängerung (6) vor einer der weiteren Widerstandsbahnen (9, 9a, 9b, 9c) getrennt ist.

2. Leiterplatte nach Anspruch 1, **dadurch gekennzeichnet, dass** der Abgleichwiderstand (7) auf den Verlängerungen (6) durch Aufdrucken erzeugt ist und die Schnitte mittels Laserlicht gebildet sind.

## Claims

1. Printed circuit board with a resistor track for an electrical device, in which a slider for providing the connection with electrical energy is movable along the resistor track and the resistor track comprises numerous metal strips which are aligned transversely with respect to the main direction in which said resistor track extends, run at a distance from one another and are interconnected on one side by a defined, electrical resistor, in particular for a potentiometer of a lever sensor for the level indication in a fuel tank, regions of metal strips (3) having extensions (6) towards one side of the resistor track (2) which are bridged by an adjusting resistor (7) and the adjusting resistor (7) being designed for isolating resistor regions by cuts running transversely with respect to the extensions (6), **characterized in that** the adjusting resistor (7) comprises a plurality of further resistor tracks (9, 9a, 9b, 9c) running in parallel, at a distance from one another, transversely with respect to the extensions (6), where in order to increase the electrical resistance between two metal strips (3) at least one extension (6) is separated before one of the further resistor tracks (9, 9a, 9b, 9c).

2. Printed circuit board according to Claim 1, **characterized in that** the adjusting resistor (7) is produced on the extensions (6) by printing thereon and the cuts are formed by means of laser light.

## Revendications

1. Carte à circuits imprimés, ayant une piste résistive pour un appareil électrique, sur laquelle un curseur peut se déplacer le long de la piste résistive pour établir une liaison avec de l'énergie électrique et sur laquelle la piste résistive est composée de nombreuses bandes métalliques, orientées perpendiculairement à la direction de sa dimension principale, s'étendant à une certaine distance les unes des autres et reliées les unes aux autres sur un côté par une résistance électrique définie, destinée notamment à un potentiomètre d'un codeur de levier pour l'affichage d'un niveau dans un réservoir de carburant, des zories des bandes métalliques (3) comportant, sur un côté de la piste résistive (2), des prolongations (6) pontées par une résistance de réglage (7) et la résistance de réglage (7) ayant des découpes orientées perpendiculairement aux prolongations (6) permettant de séparer des zones résistives, **caractérisée par le fait que** la résistance de réglage (7) est composée de plusieurs autres pistes résistives (9, 9a, 9b, 9c) parallèles les unes aux autres et écartées les unes des autres, où au moins une prolongation (6) de l'une des autres pistes résistives (9, 9a, 9b, 9c) est coupée pour augmenter la résistance électrique entre deux bandes métalliques (3).

2. Carte à circuits imprimés **caractérisée par le fait que** la résistance de réglage (7) est produite par impression en surcharge sur les prolongations (6) et que les découpes sont formées au moyen d'un rayon laser.
